Europäisches Patentamt

European Patent Office

Office européen des brevets

(11) Publication number: **0 511 663 A1**

# EUROPEAN PATENT APPLICATION

(21) Application number: **92107345.8**

(22) Date of filing: **29.04.92**

(51) Int. Cl.⁵: **C30B 15/10**, C30B 15/14

(30) Priority: **30.04.91 JP 128624/91**

(43) Date of publication of application:
**04.11.92 Bulletin  92/45**

(84) Designated Contracting States:
**DE FR GB**

(71) Applicant: **OSAKA TITANIUM COMPANY LIMITED**
**1, Higashihama-cho Amagasaki Hyogo(JP)**

(72) Inventor: **Kaneko, Kyojiro**
**1-10-206, Shirakawa 3-chome Ibaraki, Osaka(JP)**

(74) Representative: **Wächtershäuser, Günter, Dr.**
**Tal 29**
**W-8000 München 2(DE)**

(54) **Method of producing silicon single crystal.**

(57)  The inner surface of the induction coil 41 is coated with the insulating layer 43 made of the high-melting-point insulating material to form the melt vessel 40. Silicon is electro-magnetically molten within the melt vessel 40 to draw up the silicon melt 70, whereby producing the single crystalline rod 73. The silicon melt 70 is stuck to the insulating layer 43 to be suppressed from being stirred. The insulating layer 43 is cooled with cooling the induction coil 41 with water to prevent the contaminants from being eluted.

FIGURE 1

[Field of the Invention]

The present invention relates to a method or producing a silicon single crystal by the electro-magnetic melting method and the CZ drawing-up method in combination.

[Prior Art ]

A silicon single crystal is indispensable to materials of various kinds of semiconductor and a highly efficient solar cell. The CZ method, in which a single crystalline rod is drawn up from a silicon melt, and the FZ method, in which a polycrystalline silicon rod is inserted into an induction coil to form a single crystal, have been known as an industrial method of producing said silicon single crystal.

The CZ method is reduced in number of processes and improved in yield and thus economy as compared with the FZ method but the former can not obtain the single crystal as superior in quality as that obtained by the latter. It has been the greatest reason of a deterioration of the single crystal in quality in the CZ method that a quartz crucible housing a silicon melt is consumed to contaminate said silicon melt with impurities from said quartz crucible. Another great problem in the CZ method consists in that it is difficult to continuously draw up the silicon melt for a long time. It is possible in principle to make a specific resistance of said single crystalline rod constant by continuously drawing up the silicon melt for a long time and thus said yield can be remarkably improved and an efficiency in an operation of a furnace can be improved but these requirements have not been satisfied. The greatest reason for it consists in a consumption of the quartz crucible as in said deterioration of the single crystal in quality.

Recently, it is being given attention with such circumstances as a background that an electro-magnetic melting process is introduced into the CZ method. The electro-magnetic melting method is a so-called floating melting method in which a water-cooled electrically conductive crucible divided in a circumferential direction is used to melt a material within said crucible by an electro-magnetic field under the floating condition and its principle has been used also in apparatus for producing a polycrystalline silicon disclosed in Japanese Patent Application Laid-Open No. Sho 61-52962, Japanese Patent Application Laid-Open No. Hei 1-264920, Japanese Patent Application Laid-Open No. Hei 2-30698 and the like. If this electro-magnetic melting method is used for the formation of the silicon melt in the CZ method, the silicon melt within the crucible is held under the condition that it is not brought into contact with an inner surface of the crucible, so that the crucible is not consumed, the contamination with impurities from the crucible being prevented, the quality of the single crystal equal to that in the FZ method being secured, and the silicon melt being able to be continuously drawn up for a long time, in principle.

[Problems to be Solved by the Invention]

However, this method has many problems yet and has not been put into practice in an industrial scale. It is thought that there are two great factors hindering an industrial ization of the CZ method using the electro-magnetic melting process. One of them is a stirring phenomenon of the silicon melt held within the crucible under the noncontact condition. This stirring phenomenon is described with reference to Fig. 3.

An electrically conductive crucible 2 divided in a circumferential direction is arranged inside an induction coil 1. The respective divided pieces of said crucible 2 are electrified by an alternating current flowing through said induction coil 1 and thus a magnetic field is applied to a silicon melt 3 within the crucible 2 in the longitudinal axial direction. As a result, said silicon melt 3 is electrified in a circumferential direction to generate Joule's heat. However, this magnetic field is inevitably weaken upward and downward due to a construction of the induction coil 1 and a stirring force is added to the silicon melt 3 by a difference of Lorentz force on the basis of such an uneven distribution of the magnetic field. And, a flow of liquid by this stirring force is remarkably intensified by an accumulation of the following three disadvantages:

The first of them consists in that the strong stirring force proportional to a power applied to the induction coil 1 is added to the silicon melt 3. The second of them consists in that the stirring force is increased in a low-frequency band. That is to say, in the electro-magnetic melting process of silicon, if an induction frequency is high, a current efficiency is improved but a skin effect is made marked, so that an eddy current does not arrive at a central portion of the silicon melt 3 within the crucible 2 and thus said central portion of the silicon melt 3 is insufficiently molten. Accordingly, in a production of a large-sized single crystalline rod 4 said induction frequency is inevitably reduced. For example, said low-frequency band of 2 to 3 kHz is selected. However, in such a low-frequency band, an electric current arrives at a depth of the silicon melt 3 within the crucible 2 to generate a strong stirring force within the silicon melt 3.

2

This is remarkably disadvantageous for said large-sized single crystalline rod 4 in these days. The third of them consists in that the silicon melt floats within the crucible 2 to be apt to move in itself.

Said flow of liquid by the stirring force is intensified incomparably with a thermal convection shown by a broken line in Fig. 3 generated by the conventional melting in the crucible by a synergism of these disadvantages. As a result, a liquid surface of the silicon melt 3 is violently surged and thus swirl defects, dislocations and the like resulting from a temperature-fluctuation are produced in the single crystalline rod 4 drawn up from the silicon melt 3 to deteriorate the single crystalline rod 4 in quality.

It is thought that another factor hindering the industrial iztion of the CZ method using the electro-magnetic process is an increased cost of electric power. That is to say, in the CZ method using the conventional electro-magnetic melting process, an almost half of the electric power applied is consumed for heating the crucible. Accordingly, in spite of directly heating silicon by an eddy current, the economy expected has not been achieved.

It is an object of the present invention to provide a method of producing a silicon single crystal capable of remarkably increasing a consumption efficiency of electric power as compared with the CZ method using the conventional electro-magnetic melting process and effectively suppressing a stirring of a silicon melt.

[Measures for Solving the Problems ]

The present inventors have developed the CZ method using a skull-melting process before in order to improve said consumption efficiency of electric power in the CZ method using the electro-magnetic melting process and suppress said stirring of silicon melt (Japanese Patent Application No. Hei 2-112050). This is a method of producing a single crystal in which an inner surface of an induction coil is coated with a high-melting-point insulating layer to use said induction coil itself as a melt vessel and silicon is molten in said melt vessel to draw up a single crystalline rod from a silicon melt within the melt vessel under the condition that a silicon skull layer is formed on an inner surface of the vessel.

According to the CZ method using the skull-melting process, a magnetic field formed by the induction coil acts upon silicon within the melt vessel directly without through the crucible, so that the consumption efficiency of electric power is increased to about 2 times that in the CZ method by the conventional indirect electro-magnetic melting process using the crucible. Since the silicon melt within the melt vessel is stuck to the silicon skull layer, a violent stirring of the melt as in the case where the silicon melt is floatedly held does not occur even in the case where a strong stirring force acts upon the silicon melt. The silicon skull layer acts as an insulator, so that the silicon melt can be prevented from being contaminated with impurities from said high-melting-point insulator and thus a purity of the silicon melt equal to that in the case where the silicon melt is floatedly held can be secured.

It has been, however, found from the investigation conducted by the present inventors after that that in the CZ method using the skull-melting process it is necessary to form the silicon skull layer along the inner surface of the melt vessel, so that solid silicon and molten silicon coexist within the melt vessel and thus a temperature of said molten silicon can not be sufficiently risen. If said temperature of the silicon melt is low, seeds for drawing up the single crystal do not become familiar with the silicon melt and thus it becomes difficult to seed. In addition, even if it is possible to seed, a diameter of the single crystalline rod drawn up is increased, so that said diameter of the single crystalline rod drawn up can not be controlled and thus there is the possibility that the diameter of the single crystalline rod drawn up is gradually increased to produce a conical rod.

In order to solve these problems, the present inventors increased the electric power to be applied to the induction coil to an extent that the silicon skull layer disappeared. Thereupon, the silicon melt within the melt vessel was heated to a temperature suitable for drawing up the single crystal. At the same time, it was made clear that the insulator was lost with a disappearance of the silicon skull layer, so that the silicon melt within the melt vessel was brought into direct contact with the high-melting-point insulator coated on the inner surface of the induction coil but the high-melting-point insulator was held at low temperatures to be prevented from acting upon the silicon melt, whereby the silicon melt can be effectively prevented from being contaminated, under the condition that the induction coil was compulsorily cooled.

A method of producing a silicon single crystal according to the present invention is characterized in that a high-melting-point insulating layer is coated on an inner surface of an induction coil acting an alternating magnetic field upon silicon in order to melt said silicon held inside to form a melt vessel, silicon being molten within said melt vessel with compulsorily cooling said induction coil, and a silicon melt within the melt vessel being heated so as to be brought into direct contact with said high-melting-point insulating layer to draw up a single crystalline rod from said silicon melt.

It is desirable that a magnetic field acting Lorentz force suppressing a flow of the silicon melt with said flow of the silicon melt upon the silicon melt is applied to the silicon melt within the melt vessel separately from an alternating magnetic field for heating silicon.

[Operation ]

In the method of producing a silicon single crystal according to the present invention, the induction coil is used also as the melt vessel and the magnetic field acts directly upon silicon within the melt vessel. The silicon melt within the melt vessel is stuck to the inner surface of the vessel to suppress the silicon melt from being stirred. No silicon skull layer exists between the silicon melt and the inner surface of the vessel and thus the temperature of the melt is risen. In spite of the direct contact of the silicon melt with the high-melting-point insulator, the silicon melt can be prevented from being contaminated with impurities from the high-melting-point insulator by compulsorily cooling the induction coil.

[Preferred Embodiment]

The preferred embodiment of the present invention will be below-described.

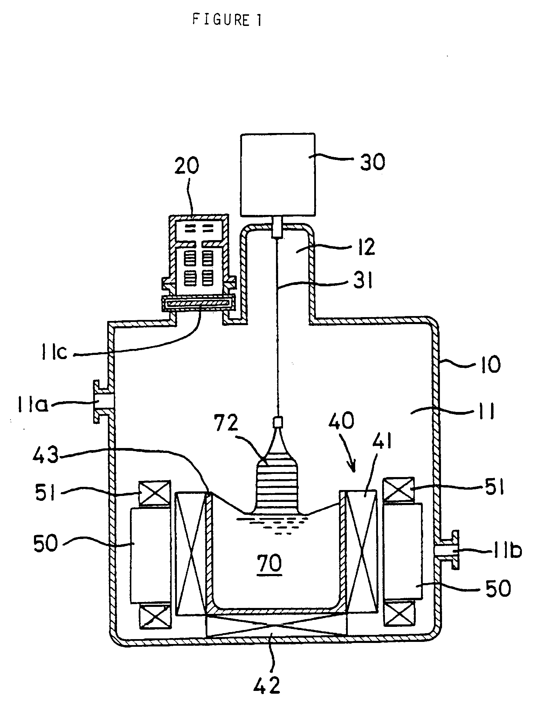

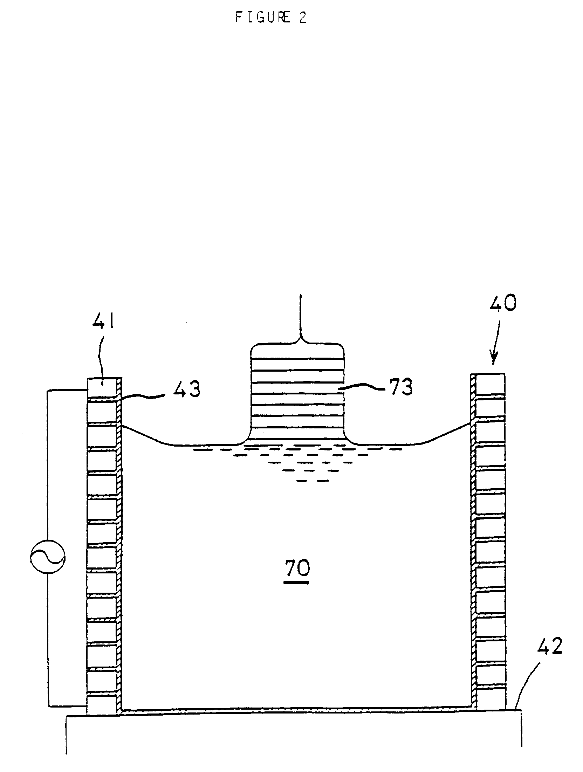

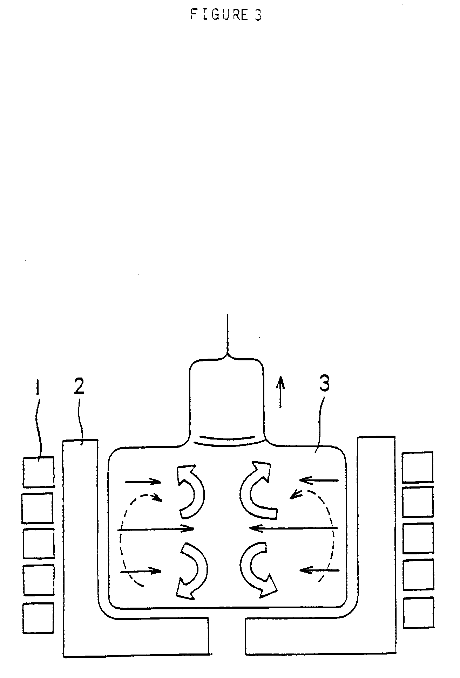

Fig. 1 is a rough sectional view showing an apparatus suitable for putting a method according to the present invention into practice. Said apparatus shown in Fig. 1 is provided with an airtight vessel 10 housing a melt vessel 40 and magnetic poles 50, 50 therein.

Said airtight vessel 10 is composed of a cylindrical melt chamber 11 and a drawing-up chamber 12 concentrically projected on said cylindrical melt chamber 11. The melt chamber 11 is provided with an inert gas-introducing port 11a and an exhaust port 11b and an electron beam gun 20 is arranged above the melt chamber 11 through a vacuum valve 11c. In addition, drawing-up means 30 having a wire 31 are arranged above said darwing-up chamber 12.

Said melt vessel 40 is arranged in a central portion within the melt chamber 11 of the airtight vessel 10. This melt vessel 40 has a circular induction coil 41 and a block 42 closing a bottom of said circular induction coil 41. These are compulsorily cooled by passing a cooling water through an inside thereof. An inner circumferential surface of the induction coil 41 and an upper surface of said block 42 are coated with an insulating layer 43 made of high-melting-point insulating materials such as $SiO_2$ and $Si_3N_4$. Said high-melting-point insulating materials forming said insulating layer 43 desirably include silicon compounds having a high electrical insulation, a high thermal conductivity and a high melting point and stable in physical property, in particular preferably $SiO_2$. The insulating layer 43 made of $SiO_2$ is formed for example as follows:

A silicone oil is applied. Methyl groups are decomposed at 300 to 400°C to form an insulating thin layer (0.3 mm or less) made of inorganic $SiO_2$. A mixture of $SiO_2$ powders and said silicone oil is applied to said thin layer in a thickness of 1 mm or less. The insulating layer 43 formed in the above describe manner is highly electrically insulative, thin and superior in thermal conductivity. Accordingly, if the insulating layer 43 is compulsorily cooled from a back side thereof, it is held at low temperatures even though its surface is brought into contact with the silicon melt and no reaction occurs between it and the silicon melt, so that no contaminant is eluted. The similar insulating layer 43 is disposed also among layers of the induction coil 41. It is desirable that a thickness of the insulating layer 43 is reduced so far as the insulation and the like are secured (preferably 1.0 mm or less).

Said magnetic poles 50, 50 are arranged on both sides of the melt vessel 40 so as to stand face to face and a horizontal direct current magnetic field is passed through said inside of the melt vessel 40 by means of coils 51, 51. The magnetic poles 50, 50 are connected with each other between back surfaces thereof through a yoke (not shown).

The method according to the present invention is put into practice by the use of the above described apparatus.

At first, massive or granular silicon as a raw material made of polycrystalline silicon is charged in the melt vessel 40. Then, the airtight vessel 10 is evacuated through said exhaust port 11b until a vacuousity within the airtight vessel 10 reaches an extent necessary for an application of electron beams. As soon as the airtight vessel 10 is evacuated, said electron beam gun 20 is operated to apply silicon as raw material charged in the melt vessel 40 with electron beams, whereby locally melting silicon as raw material, and at the same time the induction coil 41 of the melt vessel 40 is electrified. The induction coil 41 and the block 42 are being cooled.

A magnetic field acts directly upon silicon as raw material within the melt vessel 40 by electrifying the induction coil 41. However, an eddy current sufficient for melting silicon as raw material is not generated under the condition that silicon as raw material is solid. But, when silicon as raw material is applied with electron beams to form a pool, a sufficient eddy current flows through said pool to begin to enlarge the pool by a self-heating due to Joule's heat. When an appointed pool of silicon as raw material is formed, the application of electron beams is suspended.

When silicon as raw material charged in the melt vessel 40 is molten, a silicon melt 70 is brought into contact with the inner surface of the melt vessel 40 but the inner surface of the melt vessel 40 is coated with the insulating layer 43, so that a short circuit is not formed between the induction coil 41 and said silicon melt 70.

When the melt vessel 40 is filled with the silicon melt 70, said drawing-up means 30 is operated under the condition that the direct magnetic field is applied to the silicon melt 70 by means of the magnetic poles 50, 50 to draw up the silicon melt 70 from a liquid surface by means of said wire 31 with solidifying it in a conical shape under the condition that it is revolved, whereby forming a single crystalline-rod 72. At a suitable step after the application of electron beams has been finished, an inert gas, such as argon, is introduced into the airtight vessel 10 through said inert gas-introducing port 11a to switch over to an atmospheric operation. Silicon as raw material is suitably replenished in the melt vessel 40 from a hopper (not shown) within the airtight vessel 10.

It is desirable in respect of an easy addition of raw material and the like to use granular polycrystalline silicon produced by for example the fluidized particle-producing method as silicon as raw material.

The method according to the present invention has the following advantages as compared with the CZ method by the indirect electro-magnetic melting process using the conventional crucible.

The induction coil 41 is a constituent element of the melt vessel 40, so that the magnetic field generated by the induction coil 41 acts directly upon silicon within the melt vessel 40. Accordingly, the consumption efficiency of electric power is almost doubled compared with the conventional method in which a water-cooled crucible is disposed between silicon and an induction coil.

No skull layer exists but merely the silicon melt 70 exists within the melt vessel 40. Accordingly, a temperature of the silicon melt 70 is risen to make the seeding during the drawing-up process easy. In addition, said temperature of the silicon melt 70 can be speedily risen and dropped during the temperature-control, so that an expansion or a contraction of the single crystalline rod 72 during the drawing-up process can be suppressed. As a result, the single crystalline rod 72 is controlled in diameter within a control range of drawing-up speed and thus the single crystalline rod 72 has a uniform diameter all over the length thereof.

A bottom surface and an outer circumferential surface of the silicon melt 70 within the melt vessel 40 are stuck to the insulating layer 43, so that the silicon melt 70 is difficult to be stirred. In the case where the stirring occurs, Lorentz force acts upon the silicon melt 70 in the direction preventing the stirring by the direct current magnetic field formed between the magnetic poles 50, 50. Thus, also in case of large-power and low-frequency operation where a strong stirring force acts upon the silicon melt 70, no violent stirring occurs in the silicon mnelt 70 differently from the conventional method. As a result, the liquid surface of the silicon melt 70 can be suppressed from being surged and thus the swirl defects, the dislocations and the like in the single crystalline rod 72 drawn up from the silicon melt 70 can be remarkably reduced as compared with those in the conventional method.

The silicon melt 70 within the melt vessel 40 is brought into direct contact with the insulating layer 43 of the melt vessel 40 but the insulating layer 43 is thin and highly thermally conductive and cooled by means of the induction coil 41 and the block 42 compulsorily cooled with water from behind, so that no contaminant is eluted and thus the high purity of the silicon melt 70 is held and the consumption of the melt vessel 40 is prevented.

Electron beams are applied in the melting on the first stage, where silicon as raw material is locally molten, prior to the electro-magnetic melting of silicon as raw material charged in the melt vessel 40. A method, in which an electro-magnetic field is formed within a vessel under the condition that a high-melting-point electric conductor, such as graphite and molybdenum, is brought into contact with silicon within said vessel to heat first said high-melting-point electric conductor, whereby forming a pool in surrounding silicon, has been disclosed in Japanese Patent Application Laid-Open No. Hei 1-264920 and Japanese Patent Application Laid-Open No. Hei 2-30698 as the conventional melting method on the first stage. In such a melting method on the first stage, the contamination with impurities from the high-melting-point electric conductor is inevitable but in the melting method on the first stage by electron beams adopted in the method according to the present invention also such a contamination with impurities can be prevented and thus a single crystalline rod 72 can be still more improved in quality.

The results of the comparison test conducted by the present inventors will be below described to make the effects of the present invention clear.

In the apparatus shown in Fig. 1, the single crystalline rod having the diameter of 50 mm was produced by the CZ method using the direct electro-magnetic melting process without the skull layer. The electro-magnetic melting conditions and the drawing-up conditions are shown in Table 1. For comparison, the single crystalline silicon rods having the same size were produced by the CZ method using the direct electro-magnetic melting process with the skull layer, the CZ method by the conventional indirect electro-magnetic melting process and the FZ method. The quality of the respective produced single crystalline rods is shown in Table 2. Also the comparisons of the consumption of electric power and the consumed condition of the vessel were conducted between the direct melting and the indirect melting.

As found from Table 2, the consumption of electric power was saved by about 40 % as compared with the indirect electro-magnetic melting method by adopting the direct electro-magnetic melting method. In addition, in spite of the low induction frequency to an extent of 6 kHz, the surface of the silicon melt was stabilized, in particular a distribution of specific resistance was uniformed by acting the direct current magnetic field upon the silicon melt. The elimination of the skull layer led to the easy temperature-control of the silicon melt and the impurities were reduced in spite of the absence of the skull layer. And, in the case where the direct current magnetic field acted upon the silicon melt, also the disturbed convection of the silicon melt could be remarkably suppressed and thus the crystal could be uniformly grown. As a result, the silicon single crystal grown was equalized to that by the FZ method in quality.

Table 1

| Electromagnetic melting conditions | Frequency of power source | 6 kHz |
|---|---|---|
| | Inside diameter of the melt vessel (induction coil) | 150 mm |
| | Insulating material | $SiO_2$ (Silicon oxide) |
| | Thickness of the insulating layer | 0.2 mm |
| | Output of power source | 30 kw |
| | Quantity of molten silicon | 5.5 kg |
| Drawing-up conditions | Drawing-up speed | 2.0 mm/min |
| | Rotation of seeds | 20 rpm |
| | Rotation of the melt vessel | None |
| | Diameter of single crystals | 50 mm |
| | Type of semiconductor | P-type ca.1$\Omega \cdot$cm |

【Table 2 】

| Evaluation item | | Consumption of electric power | Consumption of vessel | Quality | | | | Note |
|---|---|---|---|---|---|---|---|---|
| | | | | Conc. of oxygen | Conc. of carbon | Life time | specific resist. distribution | |
| Indirect melting | | 75 kw | None | Less than analytical limit | $2$ to $7 \times 10^{16}$ (atoms/cc) | 100 to 150 ($\mu$sec) | Uneven | * 1 |
| Direct melting | ① ③ | 30 kw | None | do. | $1$ to $4 \times 10^{16}$ (atoms/cc) | 100 to 150 ($\mu$sec) | Uneven | * 2 |
| | ④ | 30 kw | None | do. | $1$ to $4 \times 10^{16}$ (atoms/cc) | 100 to 150 ($\mu$sec) | Uneven | * 3 |
| | ② ③ | 30 kw | None | $1$ to $2 \times 10^{17}$ (atoms/cc) | $2$ to $4 \times 10^{16}$ (atoms/cc) | 100 to 200 ($\mu$sec) | Slightly uneven | * 4 |
| | ④ | 30 kw | None | Less than analytical limit | $1$ to $4 \times 10^{16}$ (atoms/cc) | 150 to 250 ($\mu$sec) | Even | − |
| FZ method | | − | − | do. | $10^{16}$ or less (atoms/cc) | 250 ($\mu$sec) | Even | − |

EP 0 511 663 A1

[Table 2 continued]

[Note]

*1 The surface of the silicon melt is surged during the time when the silicon melt is being drawn up and thus the specific resistance distribution becomes uneven.

*2 It is difficult to make the diameters of crystals constant during the time when the silicon melt is being drawn up.

*3 It is difficult to control the temperature of the silicon melt during the time when the silicon melt is being drawn up.

*4 The surface of the silicon melt is slightly surged during the time when the silicon melt is being drawn up and thus the specific resistance distribution becomes slightly uneven.

① With the skul layer

② Without the skull layer

③ Without the direct current magnetic field

④ With the direct current magnetic field

In addition, the block 42 constructing the melt vessel 40 may be formed of a pancake-like coil wound in the same direction as the induction coil 41.

[Effects of the Invention]

As obvious from the above description, in the method of producing a silicon single crystal according to the present invention, the direct electro-magnetic melting process without through the crucible is used, so that the efficiency of electric power used is remarkably higher as compared with that in the CZ method by the indirect electro-magnetic melting process using the conventional crucible. Moreover, the superior quality of single crystal can be secured by suppressing the melt from being stirred. Besides, the contamination with impurities from the vessel can be prevented and thus the vessel can be prevented from being consumed. Accordingly, the silicon single crystal of high quality can be provided inexpensively.

[BRIEF DESCRIPTION OF THE DRAWINGS ]

[Figure 1]

This is a rough sectional view showing an apparatus suitable for putting the method according to the present invention into practice.

[Fig. 2]

This is a sectional view showing a melt vessel.

[Fig. 3]

This is a schematic drawing describing a stirring phenomenon of a silicon melt.

[Description of Reference Numerals ]

| 10 | Airtight vessel |
| 30 | Drawing-up means |
| 40 | Melt vessel |
| 41 | Induction coil |
| 43 | Insulating layer |
| 60 | Magnetic pole |
| 70 | Silicon melt |

**Claims**

1. A method of producing a silicon single crystal, characterized in that a high-melting-point insulating layer is coated on an inner surface of an induction coil acting an alternating magnetic field upon silicon in order to melt said silicon held inside to form a melt vessel, silicon being molten within said melt vessel with compulsorily cooling said induction coil, and a silicon melt within the melt vessel being heated so as to be brought into direct contact with said high-melting-point insulating layer to draw up a single crystalline rod from said silicon melt.

2. A method of producing a silicon single crystal as set forth in Claim 1, characterized in that a magnetic field acting a Lorentz force suppressing a flow of the silicon melt upon the silicon melt with said flow of the silicon melt is applied to the silicon melt within the melt vessel separately from said alternating magnetic field for heating silicon.

3. A method of producing a silicon single crystal as set forth in Claim 1 or Claim 2, wherein the high-melting-point insulating layer is made of $SiO_2$.

4. A method of producing a silicon single crystal as set forth in any one of Claims 1 to 3, characterized in that granular polycristalline silicon as the raw material is replenished in the melt vessel.

FIGURE 1

FIGURE 2

FIGURE 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,Y | EP-A-0 454 151 (OSAKA TITANIUM COMPANY LTD) <br> * the whole document * <br> --- | 1,3,4 | C30B15/10 <br> C30B15/14 |
| Y | FR-A-1 203 822 (SIEMENS & HALSKE AG) <br> * page 2; figure 2 * <br> --- | 1,3,4 | |
| A | GB-A-1 091 877 (DOW CORNING CORP.) <br> --- | | |
| A | US-A-4 133 969 (ZUMBRUNNEN) <br> --- | | |
| A | DE-A-1 948 194 (SIEMENS AG) <br><br> ----- | | |

|  |  |
|---|---|
| | **TECHNICAL FIELDS SEARCHED (Int. Cl.5 )** |
| | C30B |

The present search report has been drawn up for all claims

| Place of search | Date of completion of the search | Examiner |
|---|---|---|
| THE HAGUE | 11 AUGUST 1992 | COOK S.D. |